# EUROPEAN PATENT SPECIFICATION

(11) **EP 0 634 786 B1**
(45) Date of publication and mention of the grant of the patent: **05.03.1997**
(21) Application number: 94304906.4
(22) Date of filing: 04.07.1994
(51) Int. Cl.: H01L 21/00

(54) **Improved susceptor**
Verbesserte Suszeptor Ausführung
Suscepteur de conception améliorée

(30) Priority: 15.07.1993 US 93431
(43) Date of publication of application: 18.01.1995
(73) Proprietor: APPLIED MATERIALS, INC., Santa Clara, California 95054-3299 (US)
(72) Inventor: Beinglass, Israel, Sunnyvale, CA 94087 (US); Venkatesan, Mahalingam, San Jose, CA 95130 (US); Miner, Gary E., Fremont, CA 94555 (US); Gronet, Christian M., San Carlos, CA 94070 (US)
(74) Representative: Bayliss, Geoffrey Cyril

(56) References cited:
- EP-A- 0 272 141
- EP-A- 0 452 222
- EP-A- 0 513 834
- WO-A-92/20098
- US-A- 3 968 885
- IBM TECHNICAL DISCLOSURE BULLETIN., vol.31, no.1, June 1988, NEW YORK US pages 462 - 464, XP119644 'ELECTROSTATIC WAFER HOLDER FOR WAFER COOLING DURING REACTIVE ION ETCHING'

## Description

This invention relates to an improved method and apparatus for depositing polysilicon onto silicon substrates. More particularly, this invention relates to an improved susceptor for use in such apparatus

Doped or undoped silicon layers have been deposited onto silicon substrates, such as silicon wafers, using a low pressure chemical vapor deposition (CVD) process. A reaction gas mixture including a source of silicon, such as silane, disilane, silicon tetrachloride and the like, and optionally a dopant gas such as phosphine, arsine, diborane and the like, and optionally including a carrier gas (such as hydrogen, argon, nitrogen or helium), is heated and passed over a silicon substrate to deposit a silicon film on the surface of the substrate. The exact crystallographic nature of the deposited silicon depends upon the temperature of deposition. At low reaction temperatures, the deposited silicon is mostly amorphous; when higher deposition temperatures are employed, a mixture of amorphous silicon and polysilicon or polysilicon alone will be deposited.

The prior art methods use comparatively low pressures of about 200-400 millitorr for this process. Good quality films can be formed, but very low deposition rates of about 100 angstroms/min for undoped, and about 30 angstroms/min for doped, polysilicon are obtained. This low deposition rate can be overcome by processing a plurality of wafers, i.e., up to 100, at once in a batch-type processing chamber.

However, present day thin film equipment for the semiconductor industry has been moving toward single substrate processing, because the processing chambers can be made smaller and processing can be better controlled. Further, modern semiconductor vacuum processing systems have been developed to carry out more than one processing step on a substrate without removing the substrate from a vacuum environment. The use of such vacuum systems results in a reduced number of particulates that contaminate the surface of the wafers during processing, thereby improving the device yield. Such vacuum systems include a central robotic transfer chamber connected to various processing chambers, such as the Applied Materials 5000 series processing system described in US Patent 4,951,601 to Maydan et al.

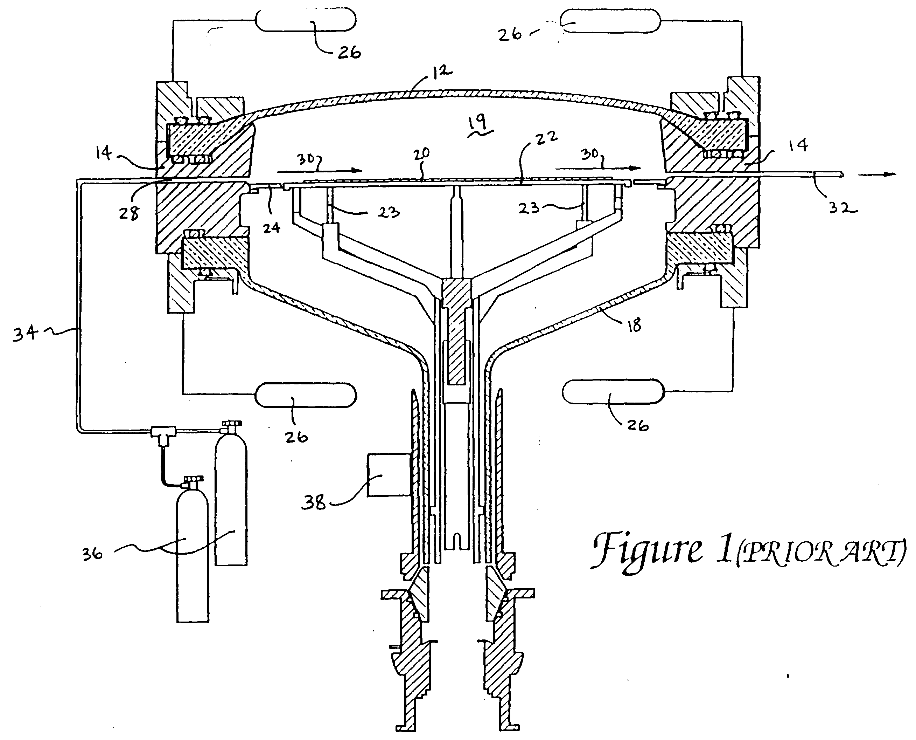

Thus, CVD equipment for single substrate processing to deposit polysilicon onto semiconductor substrates are coming into commercial use. A CVD chamber for such purpose has been described heretofore and will be described with reference to Fig. 1.

Referring to Fig. 1, a single substrate reactor 10 has a top 12, side walls 14, and a bottom 18 that define a chamber 19 into which a single wafer or substrate 20, such as a silicon wafer, can be loaded. The substrate 20 is mounted on a pedestal or susceptor 22 that is rotated by a motor (not shown) to provide a time averaged environment for the substrate 20 that is cylindrically symmetric. A susceptor circumscribing preheat ring 24 is supported by the sidewall 14 and surrounds the susceptor 22 and the substrate 20. Lifting fingers 23 pass through holes (not shown) formed through the susceptor 22 to engage the underside of the substrate 20 to lift it off the susceptor 22. The substrate 20 and the preheat ring 24 are heated by light from a plurality of high intensity lamps 26 mounted outside of the reactor 10. The top 12 and the bottom 18 of the reactor 10 are substantially transparent to light, and to enable the light from the external lamps 26 to enter the reactor 10 and heat the susceptor 22, the substrate 20 and the preheat ring 24. Quartz is a useful material for the top 12 and the bottom 18 because it is transparent to light of visible and IR frequencies; because it is a relatively high strength material that can support a large pressure difference across it; and because it has a low rate of outgassing.

During deposition, the processing gas stream flows from a gas input port 28, across the preheat ring 24 where the gases are heated, across the surface of the substrate 20 in the direction of the arrows 30 to deposit silicon films thereon, and out through an exhaust port 32. The gas input port 28 is connected, via a conduit 34, to a gas supply represented by tanks 36 that provides one or a mixture of gases. The gas concentrations and/or flow rate through the conduit 34 and each of the ports 28 and 32 are selected to produce processing gas flows and concentration profiles that optimize processing uniformity. Although the rotation of the substrate and thermal gradients caused by the heat from the lamps 26 can significantly affect the flow profile of the gases in the reactor 10, the dominant shape of the flow profile is a laminar flow from the gas input port 28 and across the preheat ring 24 and the substrate 20 to the exhaust port 32.

In a typical process producing an undoped silicon layer on a silicon wafer, a pressure of between 1,3-260 mbars (1-200 Torr) is maintained in the chamber by feeding hydrogen at about 4-10 liters/min into the chamber and adding about 200-500 cm³ of silane at a temperature of the substrate of about 560-750°C (as determined by a suitable pyrometer 38). A polysilicon film can be deposited under these conditions at a rate of about 2000 angstroms/min. The higher pressures used in the above method improves the rate of deposition of doped or undoped polysilicon.

A disadvantage with the above processing reactor 10 is that it has been found that unwanted deposition of silicon occurs on the backside of both the substrate 20 and the susceptor 22. Deposition on the backside of the substrate 20 is unacceptable from a quality control point of view. Deposition on the backside of the susceptor 22 can, as is described below, adversely affect the necessary wafer temperature measurements.

Another disadvantage with the prior art susceptor 22 is that it has a relatively high thermal mass. When the temperature in the reactor 10 is ramped up and down rapidly the susceptor 22 needs to warm up or cool down rapidly. The prior art susceptor 22, having a high thermal mass, cannot quickly warm up or cool down thus making it difficult to rapidly change the reactor 10 temperature.

Yet another disadvantage of the prior art susceptor 22 is that the substrate 20 frequently sticks to an upper surface of the susceptor. Initially, the reactor 10 is at atmospheric pressure, and the regions above and below the substrate 20 are at the same pressure. Before processing, the reactor 10 is evacuated to between 1,3-260 mbars (1-200 Torr) and the pressure on both sides of the substrate 20 equalizes to the pressure level of the reactor chamber. After deposition processing but before the substrate 20 is removed from the susceptor 22, the pressure in the reactor 10 is increased to atmospheric pressure. As the pressure in the region above the substrate increases to one atmosphere, the pressure in the region between the substrate and the susceptor lags behind and remains at a reduced pressure level causing the substrate to adhere to the susceptor. Frequently, the pressure on both sides of the substrate does not equalize quickly enough and the lift fingers rise and attempt to lift the substrate from the susceptor. In such a situation the substrate is significantly damaged causing production downtime and increased costs.

Still another disadvantage of the prior art susceptor 22 is that the temperature measurements of the substrate 20 are not always accurate. The temperature of the substrate 20 is determined by measuring the emissivity from the backside of the susceptor with the pyrometer 38. Material deposition on the backside of the susceptor affects its emissivity and results in erroneous temperature readings. To obtain accurate temperature readings, the uniformity of the emissivity of the backside of the susceptor must be kept as constant as possible, that is, material deposition on the susceptor backside must be minimized.

EP-A-0513834 discloses a wafer processing apparatus including a chamber, a pedestal enclosed within the chamber and a mechanism for lowering a semi-conductor wafer onto an upper surface of the pedestal. The pedestal assembly includes a wafer support body having a downwardly extending peripheral skirt portion with an out turned flange around its lower periphery. The chamber includes an upper enclosure portion having a peripheral wall which encircles the skirt portion of the wafer support and has an annular rebate in which the flange on the wafer support is tightly secured by through bolts.

US-A-3968885 discloses a wafer processing apparatus in which a wafer carrier is mounted on a platform which is raised and lowered into and out of sealing engagement in and aperture in a top wall of a vacuum chamber for wafer processing. An object of the invention is to overcome or minimize deposition on, firstly, the backside of the substrate and, secondly, the backside of the susceptor.

This invention provides a susceptor for receiving and supporting a substrate in a substrate processing apparatus including a processing chamber in which the susceptor is located and a gas inlet and a gas outlet through which substrate processing gas is passed to move across the susceptor, the susceptor comprising a substrate receiving surface, a step formed in a surface of the susceptor at its perimeter which, when the susceptor is located in the chamber, interfaces with and is spaced from a complemental stepped surface in a susceptor circumscribing ring located within the chamber to define a path between the susceptor and the ring, and means, formed in the stepped surface of the susceptor, for increasing turbulence of processing gas moving along the path, whereby the gas is inhibited from passing along the path.

The susceptor may include a front or upper surface including a substrate receiving pocket formed therein. The pocket may have a floor and generally upright sides. A circumscribing groove may be formed into the floor of the pocket and is dimensioned so that, when the substrate is received in the pocket, the groove lies at the perimeter of the substrate. The upright sides in conjunction with the groove operate to restrict substrate processing gas from reaching the underside of the substrate. Generally the groove lies beyond the perimeter of the substrate.

The susceptor may also include a plurality of concentric grooves formed in the floor of the substrate receiving pocket of the susceptor. When the substrate is received in the pocket it lies on top of these concentric grooves which operate to reduce the surface area upon which the substrate rests. As a result, after deposition processing, the substrate does not stick to the pocket floor and can be lifted from the susceptor without damage.

The susceptor may further include a stepped formation, formed at the perimeter of the susceptor. The stepped formation interfaces with a complemental stepped formation formed in a susceptor circumscribing preheat band located in the chamber and operates to restrict substrate processing gas from reaching a rear or backside surface of the susceptor. The stepped formation of the susceptor includes a plurality of concentric grooves formed therein. These grooves further restrict substrate processing gas from reaching the rear or backside surface of the susceptor.

The susceptor may also include a plurality of concentric grooves formed in the rear surface of the susceptor. The concentric grooves improve the uniformity of the emissivity of the rear or backside surface.

The following is a description of some specific embodiments of the invention, reference being made to the accompanying drawings in which:
Fig. 1 is a cross sectional partially schematic view of a single substrate deposition chamber of the prior art;
Fig. 2 is a partially sectioned perspective view of an improved susceptor illustrating an embodiment of this invention;
Fig. 3 is a cross-section view, through the edge of a susceptor, illustrating another embodiment of this invention; and
Fig. 4 is a cross-sectional view, through the edge of a susceptor, illustrating a further embodiment of this invention.

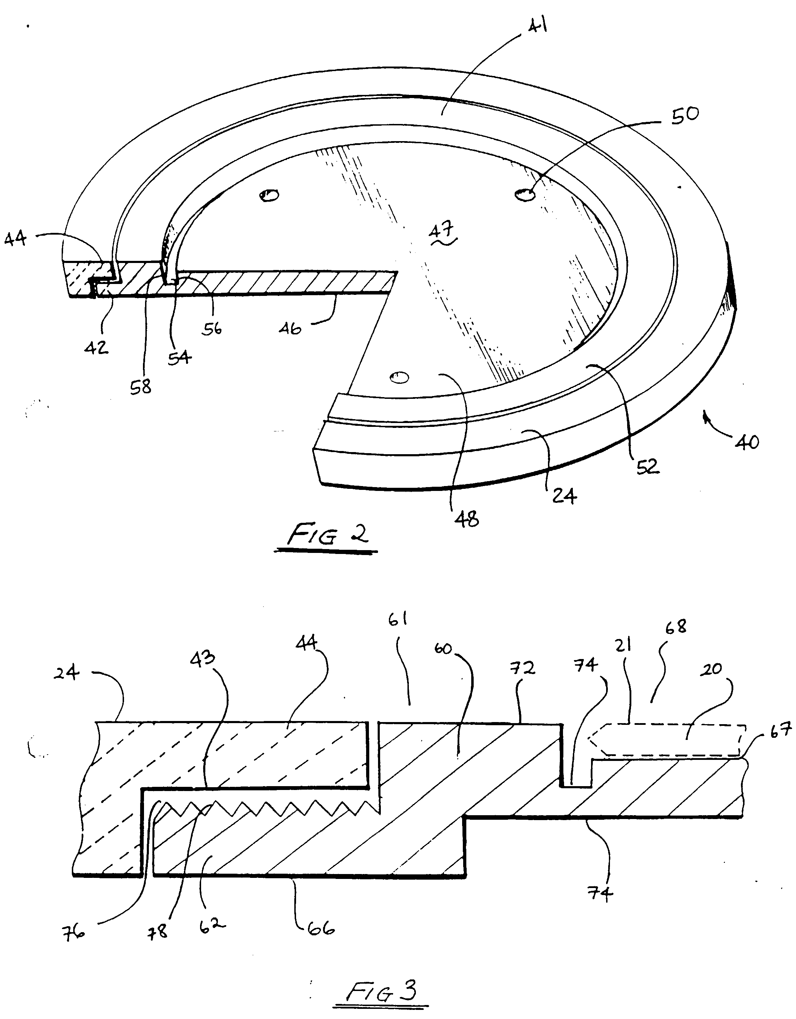

Fig. 2 is a perspective view illustrating a partially sectioned view, of an improved susceptor 40 for use in the reactor 10 (Fig. 1). The susceptor 40 has a substrate receiving or front surface 41 and a rear or backside surface 46 opposite the surface 41. Also, a stepped formation 42 is formed at the susceptor's 40 perimeter. The stepped formation 42 can be formed in the body of the susceptor 40, or could be defined by an extension mounted onto the susceptor 40. The preheat ring 24, which circumscribes the susceptor, has a complemental stepped formation 44 that mates or interfaces with the stepped formation 42.

As a result of this lapped configuration, a tortuous path is formed along which the processing gas must flow before it reaches a backside or rear surface 46 of the susceptor 40. This tortuous path both increases the distance that the processing gas must travel before it reaches the backside 46 and increases turbulence in the gas flowing along the path. The increased turbulence of the gas flow and the increased path distance results in reducing the amount of process gas flowing onto the backside 46 of the susceptor 40.

This effect could be the result of a number of factors. Firstly, the processing gases have a laminar flow as they enter the reactor 10. When these gases flow into the stepped formations 42 and 44, however, turbulence is caused in the flowing gas. As a result, the gas does not have the necessary directional flow to seep in underneath the wafer. Secondly, at the typical operating temperatures of the wafer processing reactor, the processing gases only react when they come into contact with a heated surface. As a result of the lapped configuration illustrated, the path length from the upper surface 52 to the backside 46 is substantially increased; i.e., the heated surface area, that the gas comes into contact with (and therefore reacts to) before it reaches the backside 46 of the substrate 40, is substantially increased. The effect of both of these and other factors is that most of the deposition of reactant product occurs along the walls of the stepped formation 42 and 44 and not on the backside 46 of the susceptor 40.

This is a significant result because it is believed that deposits of doped or undoped silicon or other solid materials onto the backside 46 of the susceptor 40 cause temperature variations across the susceptor 40. These deposits, in turn, cause variations, from wafer to wafer, in film thickness and properties of the deposited polysilicon films.

Further, a buildup of material on the backside 46 of the susceptor 40 causes incorrect temperature readings of the substrate 20 during deposition, also affecting the nature and deposition rate of the depositing films. As described with reference to Fig. 1 the temperature of the susceptor 40 is determined by means of a pyrometer 38 which is sensitive to the emissivity of the backside 46 of the susceptor 40. If the emissivity of the backside surface 46 of the susceptor 40 changes due to deposition of various materials thereon, the pyrometer 38 obtains a varying signal and thus gives an erroneous temperature reading. Thus, the emissivity of the backside 46 of the susceptor 40 must be kept as constant as possible. By reducing the flow of processing gas over the backside 46, the buildup of material can be minimized and the emissivity can be kept as constant as possible.

Still further, as the buildup of material on the backside 46 continues during sequential substrate processing, a wafer-to-wafer variation in the deposited films also occurs. It is desirable to keep this variation as small as possible.

By restricting the processing gases from reaching the backside 46 deposition thereon is reduced. Thus, temperature variations across the substrate 20, and on the susceptor 40, are reduced, and temperature readings of the substrate 20 during deposition are more accurate than in deposition chambers having the prior art style susceptor 22 (Fig. 1).

The substrate receiving surface 41 includes a sunken wafer receiving pocket 48 formed therein. In a pocket floor 47 of the pocket 48, three circular holes 50 are shown. These holes 50 extend through the body of the susceptor 40 and act as guides for wafer lift fingers (not shown) which, during the transfer of the wafer to or from the susceptor, move relative to the susceptor to lift the wafer out of the pocket 48 and clear of the upper surface of the susceptor 40.

Typically, the pocket 48 is formed to a level of approximately 1.02mm (0.04 inches) below the upper surface 52 of the substrate receiving surface 41. This depth is, however, variable and is determined by the thickness of the semiconductor wafer (not shown) supported in the pocket 48. Ideally, the top of the semiconductor wafer should be level with the upper surface 52 of the substrate receiving surface 41.

Also shown in this figure is an annular groove or circumscribing channel 54 which is formed about the periphery of the wafer receiving pocket 48. The groove 54 is approximately 2.03mm (0.08 inches) wide and has its bottom surface 4.45mm (0.175 inches) below the level of the pocket 48. The groove 54 is dimensioned so that, when a wafer is supported on the floor 47 of the pocket 48, the groove circumscribes the outer edge of the wafer, i.e., the diameter of the wafer is less than the diameter of the inner wall 56 of the groove 54.

In prior art susceptors, none of which include the annular groove 54, it has been found that a certain amount of processing gas seeps in underneath the wafer supported on such susceptors and causes deposition on the backside (not shown) of the wafer. This deposition can be so severe that it extends towards the center of the wafer by up to 25.4mm (1 inch) from the outer periphery of the wafer. Because of subsequent processing steps, this backside deposition is, for certain applications, unacceptable from a quality control point of view.

The sunken pocket 48 and, more particularly, the groove 54 of the susceptor 40 illustrated in this figure overcome this problem. Firstly, when a wafer (not shown) is located in the pocket 48 its upper surface is generally at the same level as the upper surface 52 of the susceptor 40. As a result, the processing gases flowing across the upper surface of the wafer are prevented, to some degree, from seeping in underneath the wafer by the outer wall 58 of the groove 54. Secondly and more importantly, if processing gas travels into the space between the wafer's outer edge and the outer wall 58, this gas first flows down into the bottom of the groove 54 and then up along its inner wall 56 before it moves under the wafer resting in the pocket 48.

This effect could be as a result of a number of factors. The processing gases have a laminar flow on entering the chamber: when these gases flow into the groove 54, however, a certain amount of turbulence is caused in the gas flow. As a result, the gas does not have the necessary directional flow to seep in underneath the wafer. Furthermore, at the typical temperatures that the wafer processing reactors operate at, the processing gases only react when they come into contact with a heated surface. As a result of the configuration illustrated above, the path length (i.e., the heated surface area) that the gas comes into contact with before it reaches the wafer is substantially increased.

The effect of both of these and other factors is that most of the deposition of reactant product occurs along the interior walls 56, 58 of the groove 54 and not on the backside of the wafer. It has been found that this feature is so successful that the amount of deposition on the wafer's backside has been reduced from about 25.4mm (1 inch) to somewhere in the region of 2-3mm (0.08 - 0.12 inches).

In Fig. 3 a further improvement to the susceptor 60 is shown. The susceptor 60 is generally similar to the susceptor 40 and includes a substrate receiving surface 61, a step formation 62, a rear or backside surface 66, a wafer receiving pocket 68, a pocket floor 67, an upper surface 72, and an annular groove 74. As these various elements are common with Fig. 2 and have already been described, no further description of these elements will be necessary. It should be noted, however, the wafer 20 (shown in broken lines), is located in the pocket 68. This wafer 20 is shown merely to illustrate approximately how it is received in the pocket 68 and that its upper surface 21 is approximately flush with the upper surface 72 of the susceptor 60.

In addition, the susceptor 60 shown in this figure has, instead of a uniformly uninterrupted backside surface 66, a circular pocket or cavity 74 formed in it from below. This pocket 74 has the effect that the thermal mass of the entire susceptor 60 is reduced. As a result, the amount of heat retained by the susceptor 60 is less than it would be if the pocket 74 had not been formed in the backside 66.

This is particularly advantageous in certain processing operations where the temperature is ramped up and down very quickly and the susceptor needs to warm up or cool down rapidly. A reduction in the thermal mass of the susceptor, as provided for in this embodiment, makes this increase and decrease in temperatures easier.

The improved susceptor 60 also includes a plurality of concentric grooves 76 formed on an overlapped surface 78 of the stepped formation 62. These concentric grooves 76 provide another means for increasing the distance that the processing gas must travel before it reaches the backside surface 66 and for increasing the turbulence in the gas flowing along the path. The increased path length and turbulence reduces the ability of the gas to pass between the susceptor 60 and preheat ring 24 and, as a result, has been found to reduce the amount of deposition on the backside surface 66 of the susceptor 60. Thus, the formation of the grooves 76 on the stepped formation 62 further enhances the effect of the stepped formations 42 and 44 of lapped configuration illustrated in Fig. 2.

It should be noted that although concentric grooves have been illustrated, alternate configurations may be employed. For example, spiraled grooves, or radially directed grooves may be used. In addition, grooves do not have to be used. Any scheme that disrupts the gas flow and increases the path length will be an effective alternate to the illustrated grooves. In the alternative, for example, a groove may be formed in the overlapping surface 43 of the stepped formation 44 of the preheat ring 24.

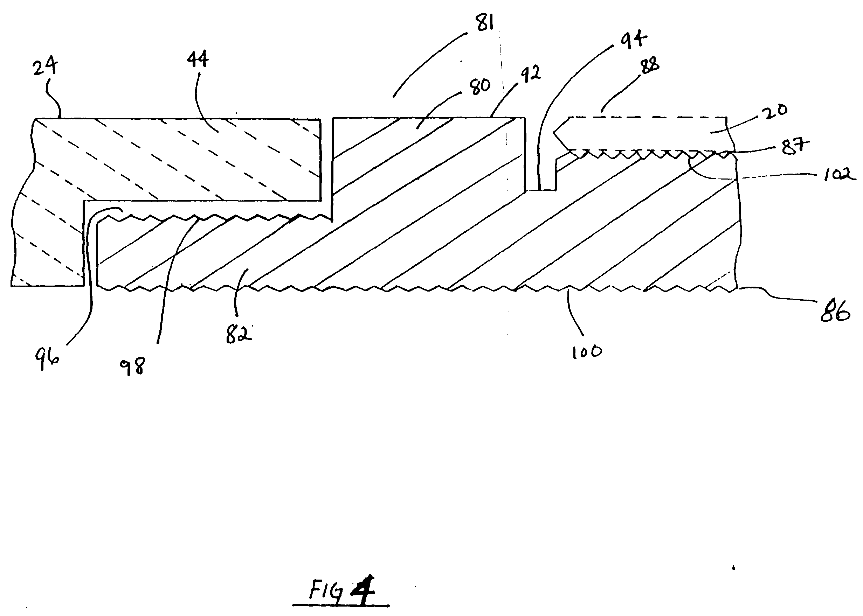

Turning now to Fig. 4 which is a cross-sectional view illustrating yet another improvement to the susceptor. The susceptor 80 is generally similar to the susceptors 40 and 60 described earlier, and includes a substrate receiving surface 81, a stepped formation 82, a rear or backside surface 86, a wafer receiving pocket 88, an upper surface 92, and annular groove or channel 74, and a plurality of concentric grooves 96 formed on the overlapped surface 98 of the stepped formation 82. As they are common with Fig. 2 and Fig. 3 and have already been described, no further description of these elements will be necessary.

In addition, the susceptor 80 shown in this figure has, a plurality of concentric grooves 100 formed on the backside 86. It has been found that the presence of the grooves 100 on the backside 86 has been successful in improving the uniformity of the emissivity of the susceptor 80. This is significant because, as described earlier, the temperature of the susceptor 80 is determined by means of a pyrometer (not shown) which is mounted on the outside of the reactor (not shown). The pyrometer is sensitive to the emissivity of the backside surface 86 of the susceptor 80. If the emissivity of the backside surface 86 of the susceptor 80 changes due to deposition of various materials thereon, or other reasons, the pyrometer obtains a varying signal and gives an erroneous temperature reading. Thus, the emissivity of the backside surface 86 of the susceptor 80 must be kept as constant as possible. It has been found that the formation of the concentric grooves 100 on the backside 86 has resulted in more accurate temperature readings of the susceptor 80 by the pyrometer.

It should be noted, that although a uniform, uninterrupted backside 86 is depicted in the figure, the presence of the grooves 100 work equally well if a circular pocket similar to that illustrated in Fig. 3 were formed on the backside 86. Furthermore, although concentric grooves 100 are illustrated alternate roughening formations may be employed. For example, spiralling or radially directed grooves may be used.

The improved susceptor 80 also includes a plurality of concentric grooves 102 formed in a floor surface 87 of the wafer pocket 88 in which the substrate or wafer 20 is located. It has been found that in prior art susceptors after deposition processing, due to the evacuated pressure levels created in the reactor 10, the substrate 20 has a tendency to adhere or stick to the floor surface 87 of the pocket 88 for a short but finite period of time after the pressure in the reactor 10 is raised to atmospheric pressure. Because it takes some finite period of time to equalize the pressure on both sides of the substrate 20, there is a significant possibility that the lifting fingers may engage the substrate 20 and attempt to separate the it from the susceptor 80 before the pressure is equalized thereby causing significant damage to the substrate 20.

The concentric grooves 102 provide a means for reducing the contact area between the substrate 20 and the surface 87 of the pocket 88 of the substrate receiving surface 81. During the time period in which the pressure has not equalized on either side of the substrate 20, this reduction in surface area reduces the force exerted on the substrate 20 thereby reducing the amount of force required to separate the substrate 20 from the floor surface 87 and consequently reducing the possibility of damage to the substrate 20.

The concentric grooves 102 have been illustrated with the annular groove 94. However, the grooves 102 address a different problem than the annular groove 94 and the grooves 102 and 94 could either be used independently or together with each other.

Finally, although concentric grooves 102 are illustrated, alternate roughening formations may be employed. For example, spiralling grooves rather than concentric grooves could be formed on the floor -87 to provide an alternate means for reducing the contact area between the substrate 20 and the pocket floor 87.

The processing chamber of the invention and the described improvements to the susceptor can be employed alone or could be part of a multi-chamber vacuum processinq system as described above.

## Claims

1. A susceptor for receiving and supporting a substrate in a substrate processing apparatus including a processing chamber (10) in which the susceptor (40) is located and a gas inlet (34) and a gas outlet (32) through which substrate processing gas is passed to move across the susceptor, the susceptor comprising:
(a) a substrate receiving surface (22);
(b) a step (42) formed in a surface of the susceptor at its perimeter which, when the susceptor is located in the chamber, interfaces with and is spaced from a complemental stepped surface (44) in a susceptor circumscribing ring located within the chamber (24) to define a path between the susceptor and the ring; and
(c) means (76), formed in the stepped surface (78) of the susceptor, for increasing turbulence of processing gas moving along the path, whereby the gas is inhibited from passing along the path.

2. A susceptor as recited in claim 1, wherein the means for increasing the turbulence includes at least one groove (76) formed in the stepped surface (78).

3. A susceptor as recited in claim 2, wherein the means for increasing the turbulence includes a plurality of circumscribing grooves (76) formed in the stepped surface (78).

4. A susceptor as recited in any of claims 1 to 3, further comprising means (102) for reducing the area of contact between a surface of the substrate (20) and the substrate receiving surface (87).

5. A susceptor as recited in claim 4, wherein the means for reducing the area of contact between the substrate surface and the substrate receiving surface (87) of the susceptor includes a formation (102) which causes the substrate receiving surface to have an undulating characteristic.

6. A susceptor as recited in claim 5, wherein the undulating characteristic is provided by a plurality of concentric grooves (102) formed in the substrate receiving surface.

7. A susceptor as recited in any of the preceding claims, further comprising a substrate receiving pocket (88) formed therein, the pocket having a floor (67) and generally upright sides and being sizes to receive the substrate therein, and wherein the floor of the pocket defines the substrate receiving surface.

8. A susceptor as recited in claim 7, wherein a circumscribing channel (54) is formed in the floor (67) of the pocket and being dimensioned so that, when the substrate (20) is received in the pocket, the channel lies at or beyond the perimeter of the substrate, such that the upright sides in combination with the channel act to restrict gas from reaching the underside of the substrate.

9. A susceptor as recited in any of the preceding claims, further comprising a rear surface (86) opposite the substrate receiving surface (102), the rear surface having an undulating characteristic (100) serving to improve the uniformity of emissivity of the rear surface.

10. A susceptor as recited in claim 9, wherein the undulating characteristic of the rear surface (86) is formed by a plurality of grooves (102) formed in the rear surface.

11. A susceptor as recited in claim 9 or claim 10 further comprising a cavity formed in the rear surface.

## Patentansprüche

1. Suszeptor für die Aufnahme und das Tragen eines Substrats in einer Substratbehandlungsvorrichtung, welche eine Behandlungskammer (10), in der der Suszeptor (40) angeordnet ist, und einen Gaseinlaß (34) sowie einen Gasauslaß (32) aufweist, durch welche ein Substratbehandlungsgas so zugeführt wird, daß es sich quer über den Suszeptor bewegt, wobei der Suszeptor
(a) eine Substrataufnahmefläche (22),
(b) eine in einer Oberfläche des Suszeptors an seinem Umfang ausgebildete Stufe (42), die, wenn der Suszeptor in der Kammer angeordnet ist, an eine komplementäre abgestufte Fläche (44) in einem den Suszeptor umgebenden Ring, der in der Kammer (24) angeordnet ist, angepaßt ist und einen Abstand zu ihr hat, wodurch zwischen dem Suszeptor und dem Ring ein Weg gebildet wird, und
(c) eine Einrichtung (76) aufweist, die in der abgestuften Fläche (78) des Suszeptors zur Erhöhung der Turbulenz des sich längs des Weges bewegenden Behandlungsgases ausgebildet ist, wodurch das Gas an einem Durchgang längs des Wegs gehindert wird.

2. Suszeptor nach Anspruch 1, bei welchem die Einrichtung zur Erhöhung der Turbulenz wenigstens eine Nut (76) aufweist, die in der abgestuften Fläche (78) ausgebildet ist.

3. Suszeptor nach Anspruch 2, bei welchem die Einrichtung zum Erhöhen der Turbulenz eine Vielzahl von einen Kreis beschreibenden Nuten (76) aufweist, die in der abgestuften Fläche (78) ausgebildet sind.

4. Suszeptor nach einem der Ansprüche 1 bis 3, welcher weiterhin eine Einrichtung (102) zum Verringern der Kontaktfläche zwischen einer Oberfläche des Substrats (20) und der Substrataufnahmefläche (87) aufweist.

5. Suszeptor nach Anspruch 4, bei welchem die Einrichtung zum Verringern der Kontaktfläche zwischen der Substratoberfläche und der Substrataufnahmefläche (87) des Suszeptors eine Ausgestaltung (102) aufweist, die der Substrataufnahmefläche eine Wellungscharakteristik gibt.

6. Suszeptor nach Anspruch 5, bei welchem die Wellungscharakteristik durch eine Vielzahl von konzentrischen Nuten (102) bereitgestellt wird, die in der Substrataufnahmefläche ausgebildet sind.

7. Suszeptor nach einem der vorhergehenden Ansprüche, welcher weiterhin eine in ihm ausgebildete Substrataufnahmetasche (88) aufweist, die einen Boden (67) und insgesamt hochstehende Seiten hat und die für die Aufnahme des Substrats in ihr bemessen ist, wobei der Boden der Tasche die Substrataufnahmefläche bildet.

8. Suszeptor nach Anspruch 7, bei welchem in dem Boden (67) der Tasche ein einen Kreis beschreibender Kanal (54) ausgebildet und so bemessen ist, daß, wenn das Substrat (20) in der Tasche aufgenommen ist, der Kanal an dem Umfang oder jenseits des Umfangs des Substrats liegt, wodurch die hochstehenden Seiten in Kombination mit dem Kanal so wirken, daß das Gas gehindert wird, die Unterseite des Substrats zu erreichen.

9. Suszeptor nach einem der vorhergehenden Ansprüche, welcher weiterhin eine der Substrataufnahmefläche (102) gegenüberliegende hintere Fläche (86) aufweist, die eine Wellungscharakteristik (100) hat, welche dazu dient, die Gleichförmigkeit des Emissionsgrads der hinteren Fläche zu verbessern.

10. Suszeptor nach Anspruch 9, bei welchem die Wellungscharakteristik der hinteren Fläche (86) durch eine Vielzahl von Nuten (102) erreicht wird, die in der hinteren Fläche ausgebildet sind.

11. Suszeptor nach Anspruch 9 oder Anspruch 10, welcher weiterhin einen in der hinteren Fläche ausgebildeten Hohlraum aufweist.

## Revendications

1. Suscepteur destiné à recevoir et supporter un substrat dans un appareil de traitement de substrats comprenant une chambre de traitement (10) dans laquelle le suscepteur (40) est placé et une entrée de gaz (34) et une sortie de gaz (32) à travers lesquelles un gaz de traitement de substrats passe pour parcourir le suscepteur, le suscepteur comportant :
(a) une surface (22) de réception de substrat ;
(b) un épaulement (42) qui est formé dans une surface du suscepteur, à son périmètre et qui, lorsque le suscepteur est placé dans la chambre, est en interface avec et est espacé d'une surface épaulée complémentaire (44) située dans un anneau entourant le suscepteur et placé dans la chambre (24) afin qu'un passage soit défini entre le suscepteur et l'anneau ; et
(c) des moyens (76) formés dans la surface épaulée (78) du suscepteur et destinés à accroître la turbulence du gaz de traitement parcourant le passage, grâce à quoi le gaz ne peut pas se déplacer le long du passage.

2. Suscepteur selon la revendication 1, dans lequel des moyens destinés à augmenter la turbulence comprennent au moins une gorge (76) formée dans la surface épaulée (78).

3. Suscepteur selon la revendication 2, dans lequel les moyens destinés à augmenter la turbulence comprennent plusieurs gorges périphériques (76) formées dans la surface épaulée (78).

4. Suscepteur selon l'une quelconque des revendications 1 à 3, comportant en outre des moyens (102) destinés à réduire l'aire de contact entre une surface du substrat (20) et la surface (87) de réception du substrat.

5. Suscepteur selon la revendication 4, dans lequel les moyens destinés à réduire l'aire du contact entre la surface du substrat et la surface (87) de réception de substrat du suscepteur comprennent une conformation (102) qui confère une caractéristique ondulée à la surface de réception du substrat.

6. Suscepteur selon la revendication 5, dans lequel la caractéristique ondulée est produite par plusieurs gorges concentriques (102) formées dans la surface de réception du substrat.

7. Suscepteur selon l'une quelconque des revendications précédentes, comportant en outre une poche (88) de réception de substrat formée dans ce suscepteur, la poche ayant un fond (67) et des côtés orientés globalement vers le haut et étant dimensionnée pour loger le substrat, le fond de la poche définissant la surface de réception du substrat.

8. Suscepteur selon la revendication 7, dans lequel une rainure périphérique (54) est formée dans le fond (67) de la poche et est dimensionnée de manière que, lorsque le substrat (20) est reçu dans la poche, la rainure s'étende à ou au-delà du périmètre du substrat, afin que les côtés orientés vers le haut agissent, en combinaison avec la rainure, pour empêcher le gaz d'atteindre le côté inférieur du substrat.

9. Suscepteur selon l'une quelconque des revendications précédentes, comportant en outre une surface arrière (86) opposée à la surface (102) de réception de substrat, la surface arrière ayant une caractéristique ondulée (100) servant à améliorer l'uniformité de l'émissivité de la surface arrière.

10. Suscepteur selon la revendication 9, dans lequel la caractéristique ondulée de la surface arrière (86) est formée par plusieurs gorges (102) formées dans la surface arrière.

11. Suscepteur selon la revendication 9 ou la revendication 10, présentant en outre une cavité formée dans la surface arrière.
